# EUROPEAN PATENT APPLICATION

(11) **EP 1 833 081 A1**
(43) Date of publication of application: **12.09.2007**
(21) Application number: 05814498.1
(22) Date of filing: 06.12.2005
(51) Int. Cl.: H01L 21/027, G03F 7/20

(54) **EXPOSURE APPARATUS AND METHOD FOR MANUFACTURING DEVICE**

(30) Priority: 07.12.2004 JP 2004353948
(71) Applicant: NIKON CORPORATION, Tokyo 100-8831 (JP)
(72) Inventor: NAKAGAWA, Chiaki c/o NIKON CORPORATION, Tokyo 1008331 (JP)
(74) Representative: HOFFMANN EITLE
(86) International application number: PCT/JP2005/022371
(87) International publication number: WO 2006/062096

(57) **Abstract**

To provide an exposure apparatus that allows an understanding of the condition of the apparatus and that can prevent a leakage or scattering of a liquid. The exposure apparatus (EX) includes a display apparatus (D) that indicates at least one of a status of filling of an optical path space (K1) of the exposure light (EL) with the liquid (LQ) and a status of recovering of the liquid (LQ) from the optical path space (K1).

## Description

### TECHNICAL FIELD

The present invention relates to an exposure apparatus that exposes a substrate via a liquid.

Priority is claimed on Japanese Patent Application No. 2004-353948, filed on December 7, 2004, the contents of which are incorporated herein by reference.

### BACKGROUND ART

In a photolithographic process, one of manufacturing processes of micro devices such as semiconductor devices and liquid crystal display devices, an exposure apparatus is used that projects an image of a pattern formed on a mask onto a photosensitive substrate. This exposure apparatus has a mask stage for supporting the mask and a substrate stage for supporting the substrate, and projects an image of a pattern of the mask onto the substrate via a projection optical system while sequentially moving the mask stage and the substrate stage. In the manufacture of a micro device, in order to increase the density of the device, it is necessary to make the pattern formed on the substrate fine. In order to address this necessity, even higher resolution of the exposure apparatus is desired. As one means for realizing this higher resolution, there is proposed a liquid immersion exposure apparatus as disclosed in PCT International Publication No. WO 99/49504, in which an exposure process is performed in a condition that an optical path space of the exposure light is filled with a liquid having a refractive index higher than a gas.

### DISCLOSURE OF INVENTION

### PROBLEMS TO BE SOLVED BY THE INVENTION

In the liquid immersion exposure apparatus, when the optical path space on the image plane side of the projection optical system is filled with a liquid, an operation for filling a space between the projection optical system and an object such as the substrate stage with the liquid is performed in a state with the projection optical system and the object facing each other. At that time, for example, if the operator withdraws the object facing the projection optical system, there is a possibility that the liquid will leakage or scatter.

The present invention has been achieved in view of such circumstances, and has an object to provide an exposure apparatus that allows the operator or others to know the condition of the exposure apparatus and to provide a device manufacturing method using the exposure apparatus. Furthermore, the present invention has an object to provide an exposure apparatus that can prevent a leakage or scattering of a liquid and to provide a device manufacturing method using the exposure apparatus.

### MEANS FOR SOLVING THE PROBLEM

To solve the above-described problems, the present invention adopts the following configurations that are illustrated in the embodiments and correspond to each figure. However, parenthesized reference characters affixed to the respective elements are merely examples of those elements, and they do not limit the respective elements.

According to a first aspect of the present invention, there is provided an exposure apparatus (EX) that irradiates a substrate (P) with exposure light (EL) via a liquid (LQ) to expose the substrate (P), including a display apparatus (D) that indicates at least one of a status of filling of an optical path space (K1) of the exposure light (EL) with the liquid (LQ) and a status of recovering of the liquid (LQ) from the optical path space (K1).

According to the first aspect of the present invention, the display of the display apparatus allows an understanding of at least one of the progression status when filling the optical path space of the exposure light with the liquid and the progression status when recovering the liquid from the optical path space.

According to a second aspect of the present invention, there is provided a device manufacturing method using the exposure apparatus (EX).

According to the second aspect of the present invention, devices can be manufactured by using the exposure apparatus that allows the operator or others to know at least one of the progression status when filling the optical path space of the exposure light with the liquid and the progression status when recovering the liquid from the optical path space.

According to the present invention, the operator or others can know the condition of the exposure apparatus, thus preventing the leakage or scattering of the liquid.

### BRIEF DESCRIPTION OF THE DRAWINGS

FIG. 1 is a schematic block diagram showing an embodiment of an exposure apparatus.
FIG. 2 is an enlarged view of the main part of FIG. 1.
FIG 3 is a plan view showing a substrate on a substrate stage.
FIG. 4 is a flowchart for explaining an example of an exposure process.
FIG 5 is a drawing for explaining an example of a liquid removal operation.
FIG. 6 is another drawing for explaining an example of a liquid removal operation.
FIG. 7 is still another drawing for explaining an example of a liquid removal operation.
FIG 8 is a drawing for explaining an example of displayed content on a display apparatus.
FIG. 9 is a drawing for explaining another example of displayed content on the display apparatus.
FIG. 10 is a drawing for explaining another example of displayed content on the display apparatus.
FIG 11 is a drawing for explaining another example of displayed content on the display apparatus.
FIG. 12 is a drawing for explaining another example of displayed content on the display apparatus.
FIG 13 is a drawing for explaining another example of displayed content on the display apparatus.
FIG 14 is a drawing for explaining another example of displayed content on the display apparatus.
FIG. 15 is a drawing for explaining another example of displayed content on the display apparatus.
FIG. 16 is a drawing for explaining another example of displayed content on the display apparatus.
FIG. 17 is a drawing for explaining another example of displayed content on the display apparatus.
FIG. 18 is a drawing for explaining another example of displayed content on the display apparatus.
FIG. 19 is a flowchart showing an example of a manufacturing procedure of a micro device.

### DESCRIPTION OF THE REFERENCE SYMBOLS

D: display apparatus, EL: exposure light, EX: exposure apparatus, LQ: liquid, P: substrate

### BEST MODE FOR CARRYING OUT THE INVENTION

Hereunder is a description of embodiments of the present invention with reference to the drawings. However, the present invention is not limited to this description.

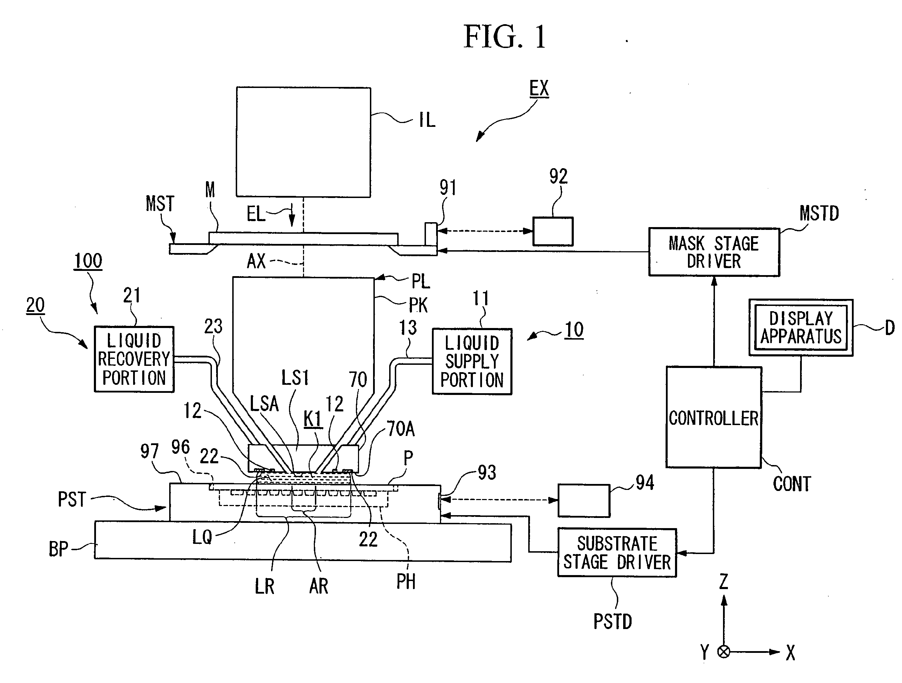

FIG. 1 is a schematic block diagram showing an exposure apparatus EX according to this embodiment. In FIG 1, the exposure apparatus EX includes: a mask stage MST capable of moving while holding a mask M; a substrate stage PST having a substrate holder PH that holds a substrate P and capable of moving the substrate holder PH holding the substrate P; an illumination optical system IL for illuminating the mask M held in the mask stage MST with exposure light EL; a projection optical system PL for projecting an image of a pattern of the mask M illuminated by the exposure light EL onto the substrate P; and a controller CONT for controlling operation of the whole exposure apparatus EX.

The exposure apparatus EX of the present embodiment is a liquid immersion exposure apparatus applicable to a liquid immersion method for substantially shortening the exposure length and improving the resolution, and also substantially expanding the depth of focus. It includes; a liquid immersion mechanism 100 for filling an optical path space K1 of the exposure light EL on the image plane side of the projection optical system PL with a liquid LQ. The liquid immersion mechanism 100 includes; a nozzle member 70 that is provided in the vicinity of an image plane of the projection optical system PL and that has supply ports 12 for supplying the liquid LQ and a collection port 22 for recovering the liquid LQ; a liquid supply mechanism 10 that supplies the liquid LQ to a space on the image plane side of the projection optical system PL via the supply ports 12 provided in the nozzle member 70; and a liquid recovery mechanism 20 that recovers the liquid LQ on the image plane side of the projection optical system PL via the collection port 22 provided in the nozzle member 70. The nozzle member 70 is formed, above the substrate P (the substrate stage PST), in an annular shape so as to surround a first optical element LS1 nearest to the image plane of the projection optical system PL, of a plurality of optical elements constituting the projection optical system PL.

The exposure apparatus EX adopts a local liquid immersion method in which the liquid LQ supplied from the liquid supply mechanism 10 locally forms, at least while projecting the pattern image of the mask M on the substrate P, an liquid immersion region LR that is greater than a projection region AR and smaller than the substrate P, on a region of one part of the substrate P which includes the projection region AR of the projection optical system PL. Specifically, the exposure apparatus EX uses the liquid immersion mechanism 100 to fill, with the liquid LQ, the optical path space K1 of the exposure light EL between an bottom surface LSA of the first optical element LS1 nearest to the image plane of the projection optical system PL and an upper surface of the substrate P. The substrate P is supported by the substrate stage PST and located on the image plane side of the projection optical system PL. The exposure apparatus EX irradiates the substrate P via the projection optical system PL and the liquid LQ between the projection optical system PL and the substrate P, with the exposure light EL that has passed through the mask M, for projecting the pattern of the mask M onto the substrate P. The controller CONT controls the liquid supply mechanism 10 to supply a predetermined amount of the liquid LQ onto the substrate P, and controls the liquid recovery mechanism 20 to recover a predetermined amount of the liquid LQ on the substrate P, for locally forming, on the substrate P, the liquid immersion region LR of the liquid LQ.

Furthermore, a display apparatus D that indicates information on the status and operation of the exposure apparatus EX is connected to the controller CONT. The display apparatus D of this embodiment includes, for example, a liquid crystal display, and indicates a progression status when the liquid immersion mechanism 100 fills the optical path space K1 of the exposure light EL with the liquid LQ and a progression status when the liquid immersion mechanism 100 recovers the liquid LQ from the optical path space K1 of the exposure light EL.

This embodiment will be described as a case where a scanning type exposure apparatus is used (a so called scanning stepper) in which while simultaneously moving the mask M and the substrate P in their respective scanning directions, the image of the pattern formed on the mask M is projected onto substrate P. In the following description, the synchronous movement direction (the scanning direction) of the mask M and the substrate P in a horizontal plane is made the X axis direction, the direction perpendicular to the X axis direction in a horizontal plane is made the Y axis direction (the non-scanning direction), and the direction that is perpendicular to the X axis and Y axis directions that coincides with an optical axis AX of the projection optical system PL is made the Z axis direction. Furthermore, rotation (inclination) directions about the X axis, the Y axis and the Z axis, are made the θX, the θY, and the θZ directions respectively. The "substrate" here includes one a sensitive material (photoresist) which is spread on a base material of a semiconductor wafer or the like, and the "mask" includes a reticle formed with a device pattern which is size reduction projected onto the substrate.

The illumination optical system IL has a light source for exposure, an optical integrator for making the illuminance distribution of a light beam emitted from the exposure light source uniform, a condenser lens for condensing the exposure light EL from the optical integrator, a relay lens system, and a field stop for setting an illumination area on the mask M formed by the exposure light EL, etc. A specified illumination area on the mask M is illuminated, by the illumination optical system IL, with the exposure light EL having a uniform illuminance distribution. For the exposure light EL radiated from the illumination optical system IL, for example emission lines (g line, h line, i line), emitted for example from a mercury lamp, deep ultraviolet beams (DUV light beams) such as the KrF excimer laser beam (wavelength: 248nm), and vacuum ultraviolet light beams (VUV light beams) such as the ArF excimer laser beam (wavelength: 193nm) and the F₂ laser beam (wavelength: 157nm), may be used. In this embodiment, the ArF excimer laser beam is used.

In this embodiment, pure water or purified water is used as the liquid LQ. Pure water can transmit not only an ArF excimer laser beam but also, for example, emission lines (g line, h line, or i line) emitted from a mercury lamp and deep ultraviolet light (DUV light) such as a KrF excimer laser beam (wavelength: 248 nm).

The mask stage MST is movable while holding the mask M. The mask stage MST, while holding the mask M, is two-dimensionally movable in a plane perpendicular to the optical axis AX of the projection optical system PL, i.e., in the XY-plane, and is finely rotatable in the θZ direction, by driving a mask stage driver MSTD including, e.g., a linear motor controlled by the controller CONT. A movement mirror 91 is provided on the mask stage MST. A laser interferometer 92 is provided at a position facing the movement mirror 91. The two-dimensional position and rotation angle in the θZ direction of the mask M on the mask stage MST, etc., are measured by the laser interferometer 92 in real time. The measurement results from the laser interferometer 92 are outputted to the controller CONT. The controller CONT drives the mask stage driver MSTD based on the measurement results from the laser interferometer 92 so as to control the position of the mask M held in the mask stage MST.

The projection optical system PL is for projecting a pattern of the mask M onto the substrate P at a predetermined projection magnification β and is constituted by a plurality of optical elements. Those optical elements are held by a lens barrel PK. In this embodiment, the projection optical system PL is a reduction system having the projection magnification P of, for example, 1/4, 1/5, or 1/8. Alternatively, the projection optical system PL may be an equal system or a magnifying system. Furthermore, at least a part of the first optical element LS1 nearest to the image plane of the projection optical system PL, of a plurality of optical elements constituting the projection optical system PL, is out from the lens barrel PK.

The substrate stage PST has the substrate holder PH for holding the substrate P and is movable on a base member BP on the image plane side of the projection optical system PL. The substrate holder PH holds the substrate P by, for example, vacuum attraction. A recess portion 96 is provided on the substrate stage PST. The substrate holder PH for holding the substrate stage PST is arranged in the recess portion 96. The upper surface 97 other than the recess portion 96 of the substrate stage PST is flat such that it is at substantially the same height as (flush with) an upper surface of the substrate P held in the substrate holder PH.

The substrate stage PST, while holding the substrate P via the substrate holder PH, is two-dimensionally movable, on the base member BP, in the XY-plane, and is finely rotatable in the θZ direction, by driving a substrate stage driver PSTD including, for example, a linear motor controlled by the controller CONT. Furthermore, the substrate stage PST is also movable in the Z axis direction and in the θX and θY directions. Therefore, the upper surface of the substrate P held in the substrate stage PST is movable in a direction of six degrees of freedom of: the X axis, Y axis, Z axis, θX, θY and θZ directions. A movement mirror 93 is provided on a side surface of the substrate stage PST. A laser interferometer 94 is provided at a position facing the movement mirror 93. The two-dimensional position and rotation angle in the θZ direction of the substrate P on the substrate stage PST, etc., are measured by the laser interferometer 94 in real time. Furthermore, the exposure apparatus EX includes an oblique incidence type focus leveling detection system (not shown in the figure) that detects surface position information of the upper surface of the substrate P supported by the substrate stage PST. The focus leveling detection system detects surface position information (positional information related to the Z-axis direction and inclination information related to the θX and θY directions) of the upper surface of the substrate P. Measurement results from the laser interferometer 94 and detection results from the focus leveling detection system are outputted to the controller CONT. The controller CONT drives the substrate stage driver PSTD based on the detection results from the focus leveling detection system so as to control the focus position (Z position) and inclination angles (θX, θY) of the substrate P such that the upper surface of the substrate P is adjusted to match the image plane of the projection optical system PL, and at the same time controls the position of the substrate P in relation to the X axis, Y axis, and θZ directions based on the measurement results from the laser interferometer 94.

Next, the liquid supply mechanism 10 and liquid recovery mechanism 20 of the liquid immersion mechanism 100 will be described. The liquid supply mechanism 10 is for supplying the liquid LQ to a space on the image plane side of the projection optical system PL. It includes: a liquid supply portion 11 that can deliver the liquid LQ; and a supply pipe 13 one end of which is connected to the liquid supply portion 11. The other end of the supply pipe 13 is connected to the nozzle member 70. In the interior of the nozzle member 70 there is formed an internal passage (supply passage) that connects the other end of the supply pipe 13 and the supply ports 12. The liquid supply portion 11 includes at least; a tank that stores the liquid LQ, a pressurizing pump, a temperature-adjusting mechanism that adjusts the temperature of the liquid LQ to be supplied, and a filter unit that removes foreign matter in the liquid LQ.

The liquid recovery mechanism 20 is for recovering the liquid LQ on the image plane side of the projection optical system PL. It includes; a liquid recovery portion 21 that can recover the liquid LQ; and a recovery pipe 23 one end of which is connected to the liquid recovery portion 21. The other end of the recovery pipe 23 is connected to the nozzle member 70. In the interior of the nozzle member 70 there is formed an internal passage (recovery passage) that connects the other end of the recovery pipe 23 and the collection port 22. The liquid recovery portion 21 includes, for example, a vacuum system (suction apparatus) such as a vacuum pump, a gas-liquid separator that separates a gas from the recovered liquid LQ, and a tank that stores the recovered liquid LQ.

The supply ports 12 that supply the liquid LQ and the collection port 22 that recovers the liquid LQ are formed in the bottom surface 70A of the nozzle member 70. A plurality of supply ports 12 are provided in the bottom surface 70A of the nozzle member 70 so as to surround the first optical element LS 1 of the projection optical system PL (the optical axis AX of the projection optical system PL). Furthermore, the collection port 22 is provided, in the bottom surface 70A of the nozzle member 70, on the outside than the supply ports 12 with respect to the first optical element LS 1 so as to surround the first optical element LS1 and the supply ports 12.

When forming the liquid immersion region LR of the liquid LQ, the controller CONT drives both of the liquid supply portion 11 and the liquid recovery portion 21. When the liquid LQ is delivered from the liquid supply portion 11 under the control of the controller CONT, the liquid LQ delivered from the liquid supply portion 11, after flowing through the supply pipe 13, is supplied from the supply ports 12 to the image plane side of the projection optical system PL via the supply passage of the nozzle member 70. Furthermore, when the liquid recovery portion 21 is driven by the controller CONT, the liquid LQ on the image plane side of the projection optical system PL, after flowing in the recovery passage of the nozzle member 70 via the collection port 22 and flowing through the recovery pipe 23, is recovered into the liquid recovery portion 21.

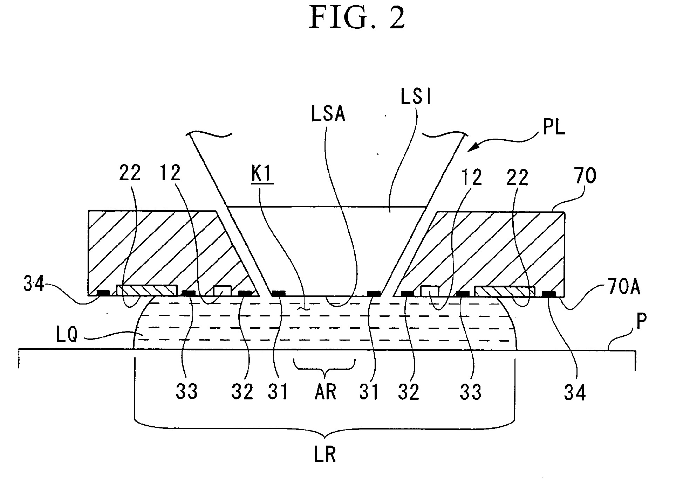

FIG. 2 shows a vicinity of the nozzle member 70. In FIG 2, a first sensor 31 that can detect the liquid LQ is provided at a predetermined position in the bottom surface LSA of the first optical element LS1 of the projection optical system PL. The first sensor 31 is provided, in the bottom surface LSA of the first optical element LS1, outside the optical path of the exposure light EL so as not to prevent the irradiation of the exposure light EL. Furthermore, second, third, and fourth sensors 32, 33, and 34 are provided at a plurality of predetermined positions in the bottom surface 70A of the nozzle member 70, respectively. The second sensor 32 is provided, in the bottom surface 70A of the nozzle member 70, on the inside than the supply ports 12 (on the projection region AR side). The third sensor 33 is provided, in the bottom surface 70A of the nozzle member 70, between the supply ports 12 and the collection port 22 in the vicinity of the collection port 22. The fourth sensor 34 is provided, in the bottom surface 70A of the nozzle member 70, on the outside than the collection port 22 with respect to the projection region AR. Detection results from the first to fourth sensors 31 to 34 are outputted to the controller CONT.

The first to fourth sensors 31 to 34 detect the presence or absence of the liquid LQ, for example, by projecting detection light downward (or toward the substrate P). The reflected light condition of the projected detection light is changed depending on the presence or absence of the liquid LQ under the first to fourth sensors 31 to 34. Therefore, by receiving the reflected light of the projected detection light, the first to fourth sensors 31 to 34 can detect the presence or absence of the liquid LQ under the respective first to fourth sensors 31 to 34. Sensors are not limited to optical sensors, but various sensors such as capacitance type sensors can be adopted.

The controller CONT can acquire the state of the liquid immersion region LR based on the detection results from the first to fourth sensors 31 to 34. More specifically, the controller CONT can determine the presence or absence of the liquid LQ in the optical path space K1 based on the detection results from the first to fourth sensors 31 to 34, and can detect the size of the liquid immersion region LR (interface area of the liquid immersion region LR). For example, when each of the first to fourth sensors 31 to 34 does not detect the liquid LQ, the controller CONT determines that the liquid LQ is not present in the optical path space K1 between the projection optical system PL and the substrate P. When each of the first and second sensors 31 and 32 detects the liquid LQ, the controller CONT determines that the liquid immersion region LR formed is relatively small and that the optical path space K1 has not been fully filled with the liquid LQ. When each of the first, second, and third sensors 31, 32, and 33 detects the liquid LQ, the controller CONT determines that the liquid immersion region LR formed has a desired size and that the optical path space K1 has been well filled with the liquid LQ. When each of the first to fourth sensors 31 to 34 detects the liquid LQ, the controller CONT determines that the liquid immersion region LR formed is relatively large.

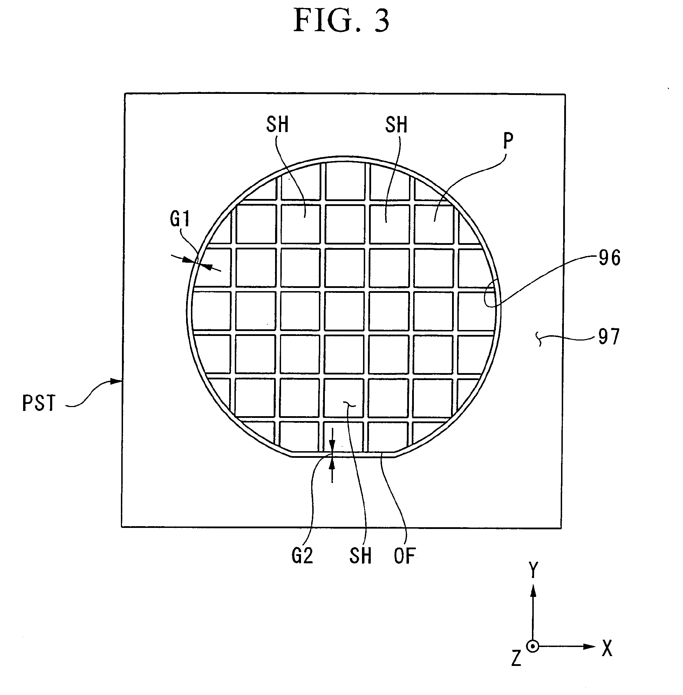

FIG. 3 is a plan view of the substrate stage PST supporting the substrate P, seen from above. The upper surface 97 of the substrate stage PST is located so as to surround the substrate P held in the substrate stage PST (substrate holder PH). A predetermined gap G1 is provided between an edge of the substrate P and the upper surface 97 of the substrate stage PST. Furthermore, a plurality of shot areas SH are established on the substrate P. The controller CONT moves the substrate stage PST along the XY direction while monitoring the output from the laser interferometer 94 so as to sequentially expose the plurality of shot areas SH established on the substrate P.

Furthermore, in this embodiment, an orientation flat portion OF, which is a cut portion, is formed in the substrate P. In an inner wall of the substrate stage PST connecting to the upper surface 97, a flat portion that corresponds in shape to the orientation flat portion OF is formed. Furthermore, a predetermined gap G2 is formed between the orientation flat portion OF and the upper surface 97 as well. In the case where a notch portion as the cut portion is formed in the substrate P, a protrusion portion corresponding in shape to the notch portion is formed on the inner wall for the recess portion 96, connecting to the upper surface 97 of the substrate stage PST. In the case where the notch portion is small enough to be capable of suppressing the penetration of the liquid LQ into the gap G1, provision of the protrusion portion on the inner side surface of the recess portion 96 may be omitted.

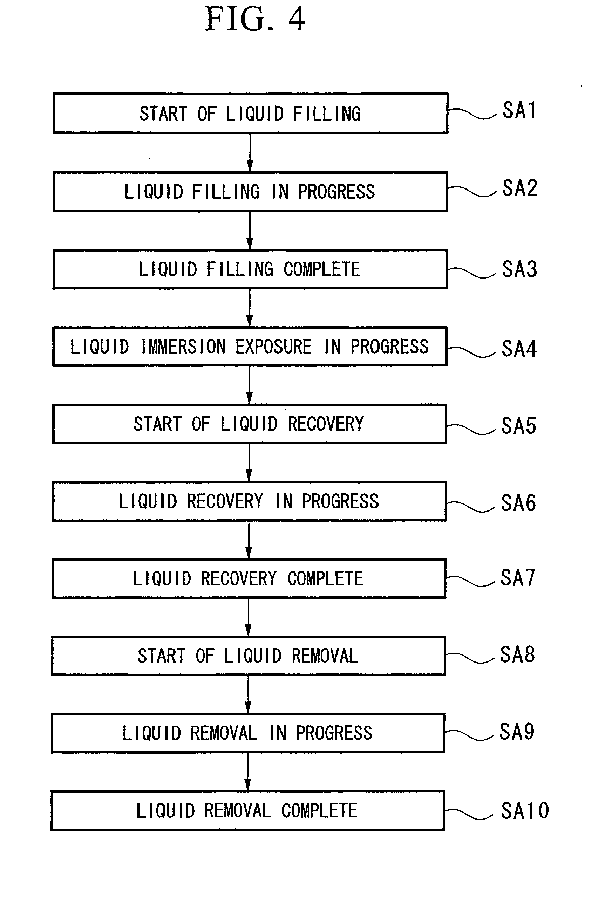

Next, a procedure for exposing the substrate P by the use of the aforementioned exposure apparatus will be described referring to the flowchart in FIG. 4.

After the substrate P to be exposed is loaded on the substrate stage PST, the controller CONT drives the substrate stage driver PSTD to make the projection optical system PL and the substrate P face each other. The controller CONT then starts an operation for filling the optical path space K1 between the projection optical system PL and the substrate P with the liquid LQ (step SA1). More specifically, the controller CONT starts supplying the liquid LQ to the space between the projection optical system PL and the substrate P by using the liquid supply mechanism 10 of the liquid immersion mechanism 100, in the condition that the projection optical system PL and the substrate P face each other.

In the following description, an operation for supplying and recovering the liquid LQ by the use of the liquid supply mechanism 10 and liquid recovery mechanism 20 of the liquid immersion mechanism 100 for filling the optical path space K1 with the liquid LQ will be appropriately referred to as a "liquid filling operation".

In step SA1, after starting the liquid filling operation, the controller CONT continues the liquid filling operation using the liquid supply mechanism 10 and liquid recovery mechanism 20 of the liquid immersion mechanism 100 for a predetermined period of time (step SA2). The controller CONT can fill the optical path space K1 with the liquid LQ by continuing the liquid filling operation for a predetermined period of time. At the time when the optical path space K1 is filled with the liquid LQ and a desired state (size) of the liquid immersion region LR is formed, the controller CONT determines that the liquid filling operation is complete (step SA3).

As described with reference to FIG. 2, in this embodiment, the first to fourth sensors 31 to 34 that can detect the state (size) of the liquid immersion region LR are provided in the bottom surface LSA of the first optical element LS 1 and the bottom surface 70A of the nozzle member 70. Therefore, the controller CONT can detect the progression status of the liquid filling operation based on the detection results from the first to fourth sensors 31 to 34. Thus, the controller CONT can predict the time until when the optical path space K1 is filled with the liquid LQ (the time until the completion of the liquid filling operation) and can determined whether the liquid filling operation has completed or not.

In the following description, a state in which the optical path space K1 is filled with the liquid LQ will be appropriately referred to as a "wet state".

Here, the liquid filling operation is performed in the condition that the projection optical system PL and the substrate P face each other. However, the liquid filling operation may be performed in the condition that the projection optical system PL and the upper surface 97 of the substrate stage PST face each other. In this case, after the space between the projection optical system PL and the upper surface 97 of the substrate stage PST is filled with the liquid LQ, the substrate stage PST may be moved in the XY direction, in the state with the liquid LQ held on the bottom surface LSA side of the projection optical system PL, so as to move the liquid immersion region LR of the liquid LQ onto the substrate P.

After the optical path space K1 between the projection optical system PL and the substrate P that faces the projection optical system PL is filled with the liquid LQ, the exposure light is exited from the illumination optical system under control of the controller CONT, and the mask K held on the mask stage MST is illuminated with the exposure light EL. The exposure light EL having passed through the mask M is shone onto the substrate P via the projection optical system PL and the liquid LQ in the optical path space K1. As a result, the substrate P is liquid immersion exposed (step SA4).

After completion of the liquid immersion exposure for the substrate P, the controller CONT stops the supply operation of the liquid supply mechanism 10, and starts an operation for recovering the liquid LQ from the optical path space K1 by using the liquid recovery mechanism 20 (step SA5). That is, in this embodiment, substantially the entirety of the liquid LQ of the optical path space K 1 is recovered every time liquid immersion exposure onto the substrate P has completed.

In the following description, an operation for recovering the liquid LQ from the optical path space K1 by the use of the liquid recovery mechanism 20 after completion of the liquid immersion exposure will be appropriately referred to as a "liquid recovery operation".

In step SA4, after starting the liquid recovery operation, the controller CONT continues the liquid recovery operation using the liquid recovery mechanism 20 of the liquid immersion mechanism 100 for a predetermined period of time (step SA6). The controller CONT can recover substantially the entirety of the liquid LQ of the optical path space K1 by continuing the liquid recovery operation for a predetermined period of time. At the time when substantially the entirety of the liquid LQ of the optical path space K1 is recovered, the controller CONT determines that the liquid recovery operation has completed (step SA7). With the completion of the liquid recovery operation, there is substantially no liquid LQ present in the optical path space K1.

Also in the liquid recovery operation, as in the liquid filling operation, the controller CONT can detect progression status of the liquid recovery operation based on the detection results from the first to fourth sensors 31 to 34. Thus, the controller CONT can acquire the time until when the liquid LQ is recovered from the optical path space K1 (the time until the completion of the liquid recovery operation) and can determine whether the liquid recovery operation has completed or not.

In the following description, a state in which there is no liquid LQ present in the optical path space K1 will be appropriately referred to as a "dry state".

Even after the liquid recovery operation is complete, there is a possibility that the liquid LQ remains on the substrate P or the substrate stage PST. Therefore, the controller CONT starts an operation for removing the liquid LQ that remains on the substrate P or the substrate stage PST by recovering the liquid LQ by suction via the collection port 22 of the nozzle member 70 while moving the substrate stage PST with respect to the collection port 22 (step SA8).

In the following description, an operation for removing the liquid LQ that remains on the substrate P or the substrate stage PST by the use of the liquid recovery mechanism 20, after completion of the liquid recovery operation, will be appropriately referred to as a "liquid removal operation".

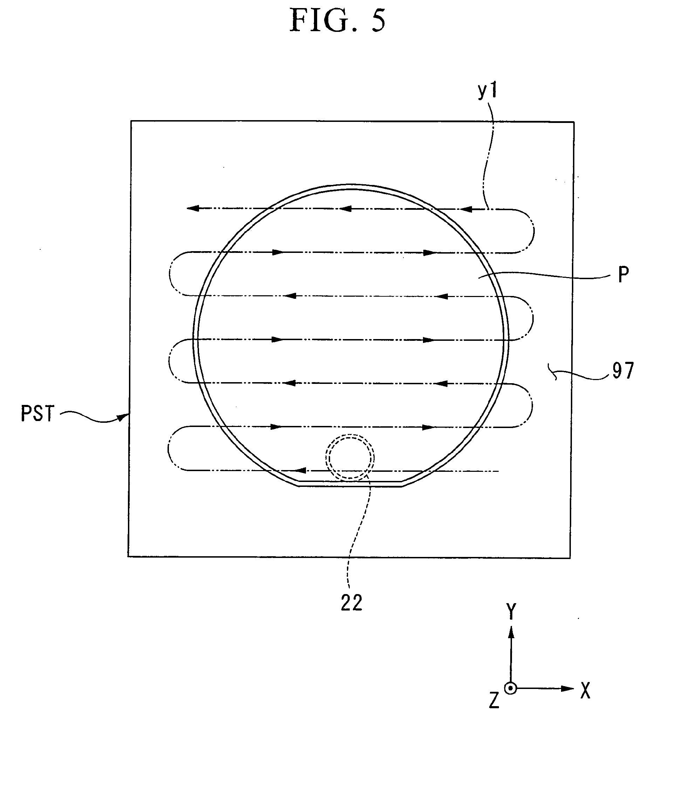

FIG 5 is a schematic showing a state in which the liquid removal operation on the substrate P and the substrate stage PST is being performed. The controller CONT moves the substrate stage PST while monitoring the output from the laser interferometer 94 such that the collection port 22 of the liquid recovery mechanism 20 and the substrate P relatively move along the broken line arrow y1 in FIG. 5. With the translation movement of the substrate stage PST along the XY plane, the collection port 22 scans substantially the entire region of the upper surfaces of the substrate P and the substrate stage PST. As a result, the liquid LQ remaining on the substrate P and the substrate stage PST is removed by suction via the collection port 22 by the liquid recovery mechanism 20, and thus is securely removed.

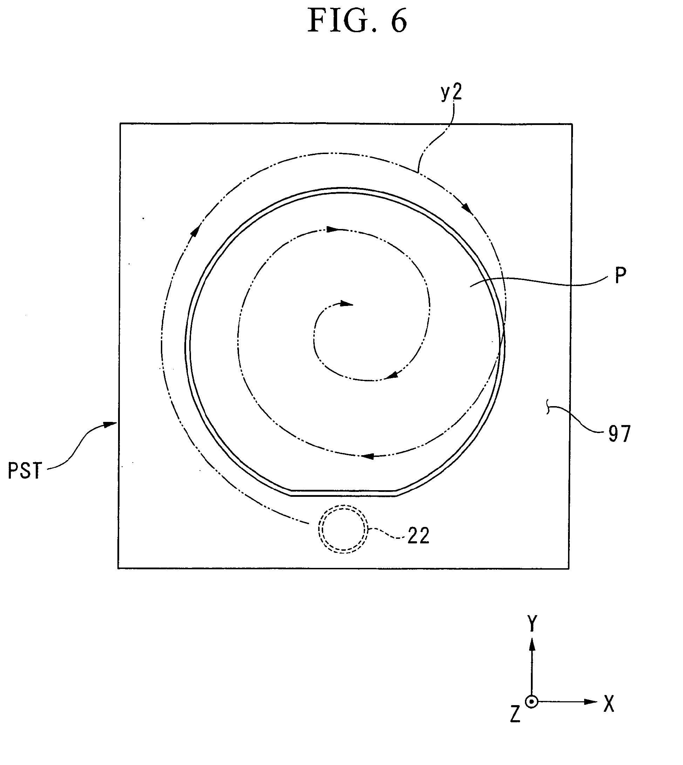

In the example shown in FIG. 5, the substrate P and the substrate stage PST move along a movement path as if to repeat, with respect to the collection port 22, a scanning movement in the X axis direction and a stepping movement in the Y axis direction. However, the movement path may be set to be any. For example, as shown by the broken line arrow y2 in FIG. 6, the substrate P and the substrate stage PST may move along a spiral movement path as if to draw a circle from outside to inside (or from inside to outside) of the substrate P. Or, they may move as if to concentrically draw multiple-sized circular paths.

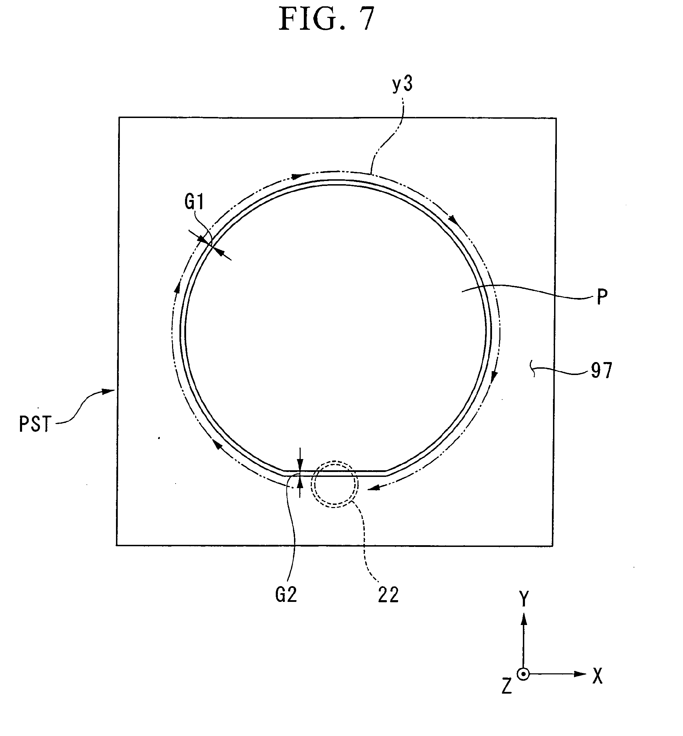

Alternatively, as shown by the broken line arrow y3 in FIG 7, the liquid removal operation may be performed via the collection port 22, while moving the substrate stage PST such that, on the substrate stage PST, the collection port 22 draws a path along the gap G1 between the edge of the substrate P and the upper surface 97 of the substrate stage PST. Furthermore, the controller CONT may intensively perform the liquid removal operation in the vicinity of the gap G2 after locating the orientation flat portion OF of the substrate P so as to face the collection port 22 of the liquid recovery mechanism 20.

In this way, the controller CONT continues, while moving the substrate stage PST, the liquid removal operation by the liquid recovery mechanism 20 for a predetermined period of time (step SA9). By continuing the liquid removal operation for a predetermined period of time, the controller CONT can remove substantially the entirety of the liquid LQ that remains on the substrate P and the substrate stage PST. At the time when the liquid LQ remaining on the substrate P and the substrate stage PST is removed, the controller CONT determines that the liquid removal operation has completed (step SA10). With completion of the liquid removal operation, there is substantially no liquid LQ present in the optical path space K1, on the substrate P, or on the substrate stage PST. After completion of the liquid removal operation, the exposure-processed substrate P is unloaded from the substrate stage PST.

The aforementioned liquid recovery operation (steps SA5 to SA7) is performed in the state with the relative position between the nozzle member 70 and the substrate stage PST being substantially maintained. That is, the liquid recovery operation is an operation for recovering the liquid LQ via suction from the collection port 22 of the liquid recovery mechanism 20 in the state with the substrate stage PST being substantially stationary with respect to the nozzle member 70. The liquid recovery operation completes in a short time. On the other hand, the liquid removal operation (steps SA8 to SA10) is performed while the nozzle member 70 and the substrate stage PST are being moved relatively. That is, the liquid removal operation is an operation for removing the liquid LQ by using the collection port 22 of the liquid recovery mechanism 20 while moving the substrate stage PST with respect to the nozzle member 70. The liquid removal operation takes longer than the liquid recovery operation.

Next, an operation of (displayed content on) the display apparatus D during the aforementioned steps SA1 to SA10 will be described. In the following description, it is assumed that the display apparatus D performs a display based on a command from the controller CONT.

The display apparatus D in this embodiment has a function to indicate information on the state and operation of the exposure apparatus EX including what is being processed by the exposure apparatus EX and various information on exposure process. More specifically, the display apparatus D has a function to indicate a progression status when the liquid immersion mechanism 100 fills the optical path space K1 of the exposure light EL with the liquid LQ and a progression status when the liquid immersion mechanism 100 removes the liquid LQ from the optical path space K1. Furthermore, the display apparatus D also has a function to indicate information on the state (operation) of the exposure apparatus EX including what was processed in the past and information (log information) including measurement results from each of the measurement apparatuses.

Furthermore, the display apparatus D also has functions, for example, indicating the state of the liquid immersion region LR, indicating the state of the substrate P, indicating information on the substrate P (information on the photoresist being used, lot information, etc.), and indicating exposure conditions (scanning speed, irradiation amount of exposure light, etc.). Moreover, the display apparatus D also has a function as a operation or a control portion that controls the exposure apparatus EX. More specifically, the display apparatus D of this embodiment includes a variety of buttons (icons). It is configured such that an operator or the like can enter operation inputs to the exposure apparatus EX by operating the buttons by means of operation input portions such as a mouse and a keyboard. In the case where the display apparatus D is a so-called touch panel, the operator or others can enter operation inputs to the exposure apparatus EX by touching predetermined positions on the screen of the display apparatus D.

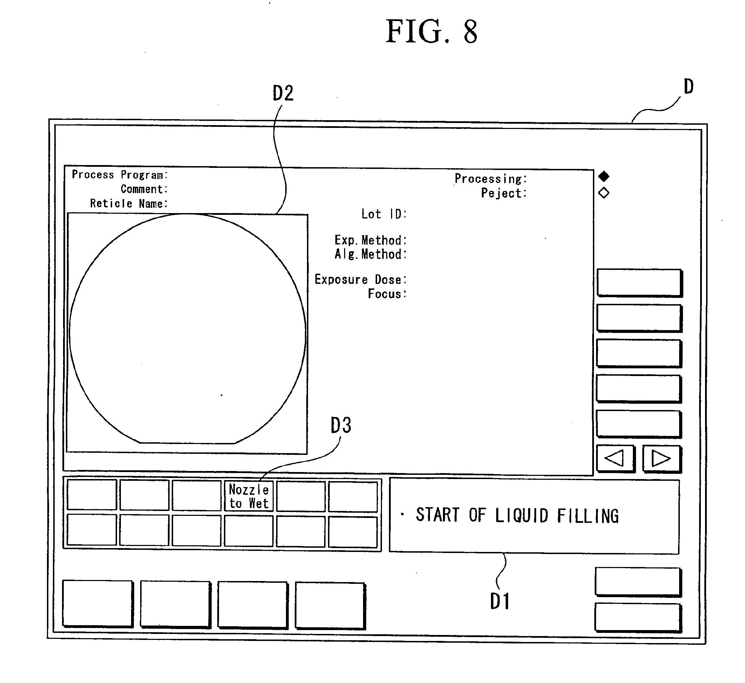

FIG 8 shows schematically an example of displayed content on the display apparatus D at the aforementioned step SA1, i.e., at the beginning of the liquid filling operation. The display apparatus D can indicate a progression status of what is being processed by the exposure apparatus EX including at least; the liquid filling operation, the liquid recovery operation, and the liquid removal operation. A first area D1 of the display screen indicates that the liquid filling operation has started by displaying the words "Start of Liquid Filling." In a second area D2 of the display screen of the display apparatus D, the state of the substrate P is visually displayed. In a third area D3 of the display screen of the display apparatus D, the state of the nozzle member 70 is displayed in words.

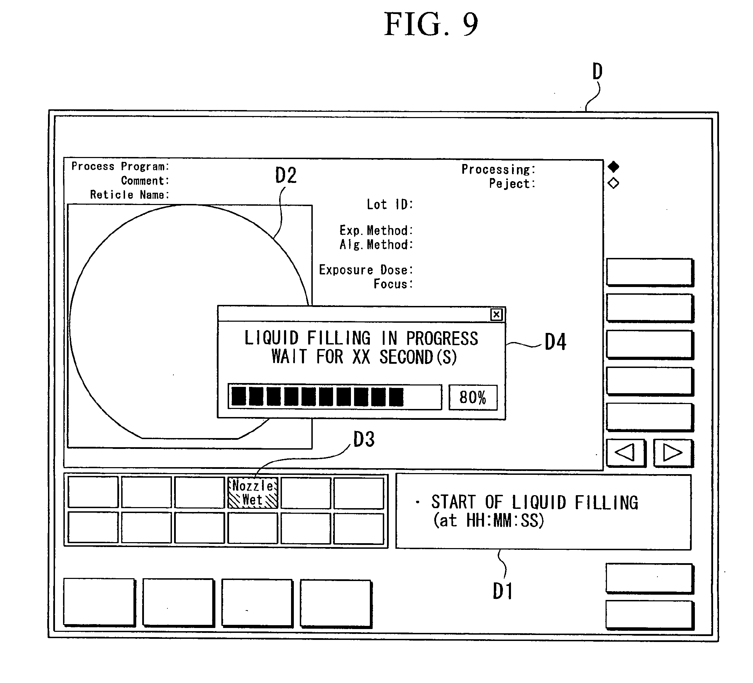

FIG 9 shows an example of displayed content on the display apparatus D at the aforementioned step SA2, i.e., during the liquid filling operation. As shown in FIG 9, the display screen of the display apparatus D indicates that, as a progression status of the liquid filling operation, the liquid filling operation is in progress. To indicate the progression status of the liquid filling operation, a window is displayed in a fourth area D4 on the display screen of the display apparatus D, which shown the progression status by displaying the words, numeric value, and graphic (progression bar). It takes a predetermined time from the start to the completion of the liquid filling operation. The display apparatus D of this embodiment indicates the time until the end of the liquid filling operation by displaying the words, numeric value, and graphic (progression bar). Furthermore, after the start of the liquid filling operation, the state of the nozzle member 70 changes from a dry state to a wet state. To indicate the state of the nozzle member 70, the displayed content in the third area D3 is changed.

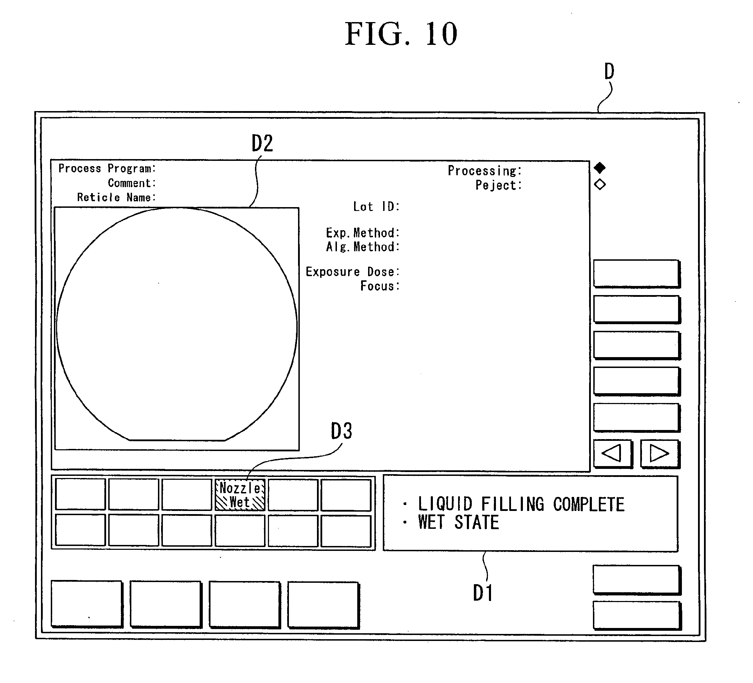

FIG 10 shows an example of displayed content on the display apparatus D at the aforementioned step SA3, i.e., at the completion of the liquid filling operation. Here, on completion of the liquid filling operation, the display apparatus D indicates that the optical path space K1 is in a state of being filled with the liquid LQ (a wet state). The first area D 1 on the display screen of the display apparatus D indicates that the optical path space K1 is in a state of being filled with the liquid LQ by displaying the words "Wet State".

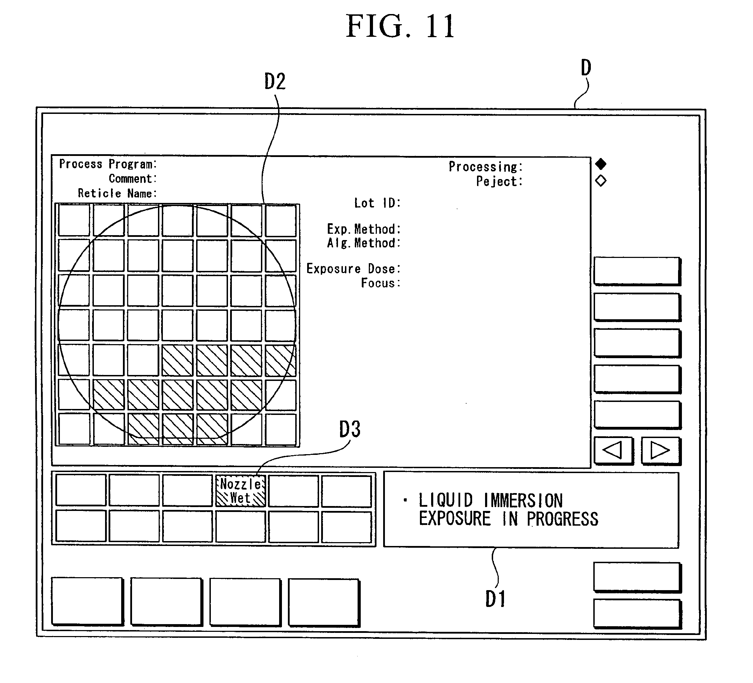

FIG. 11 shows an example of displayed content on the display apparatus D at the aforementioned step SA4, i.e., during the liquid immersion exposure. As shown in FIG 11, the first area D1 on the display screen of the display apparatus D indicates that the liquid immersion exposure is being performed by displaying the words "Liquid Immersion Exposure in Progress". Furthermore, the second area D2 on the display screen of the display apparatus D visually displays the state of the substrate P such that the exposed shot areas of the plurality of shot areas are displayed differently from the shot areas yet to be exposed.

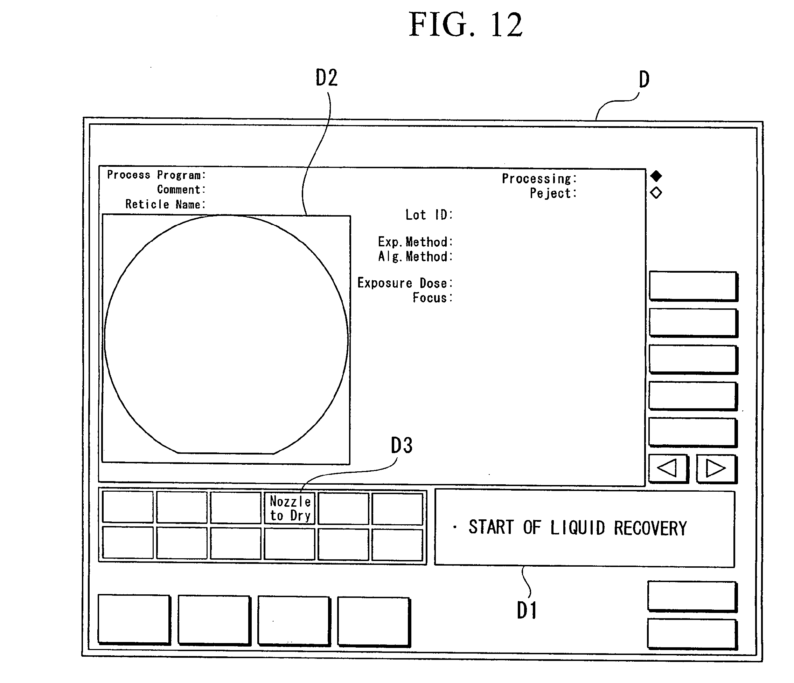

FIG. 12 shows an example of displayed content on the display apparatus D at the aforementioned step SA5, i.e., at the start of the liquid recovery operation. As shown in FIG 12, the first area D1 on the display screen of the display apparatus D indicates that the liquid recovery operation has started by displaying the words "Start of Liquid Recovery". Furthermore, the state of the nozzle member 70 changes with the start of the liquid recovery operation. Therefore, the displayed content in the third area D3 that indicates the state of the nozzle member is changed.

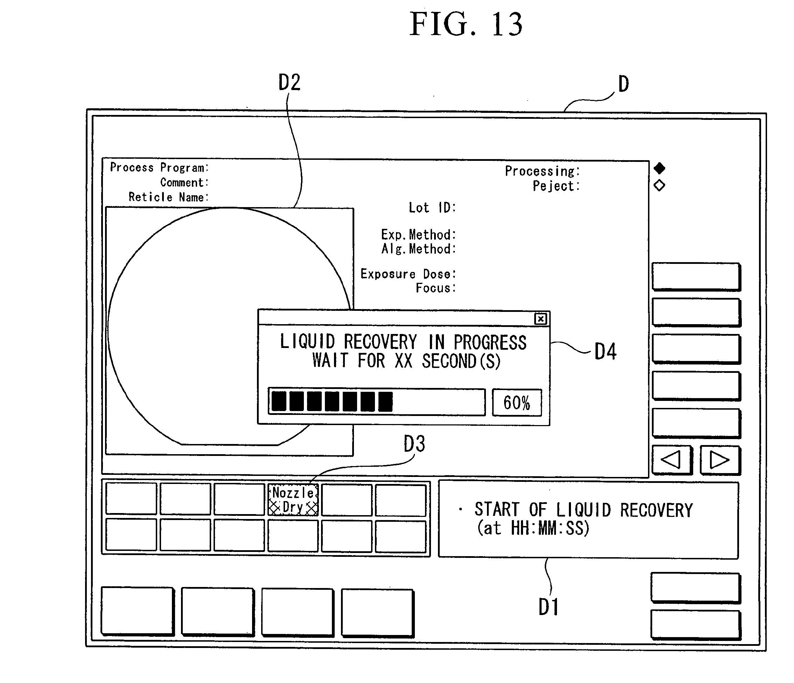

FIG. 13 shows an example of displayed content on the display apparatus D at the aforementioned step SA6, i.e., during the liquid recovery operation. As shown in FIG. 13, the display screen of the display apparatus D indicates, as a progression status of the liquid recovery operation, that the liquid recovery operation is in progress. To indicate the progression status of the liquid recovery operation, a window is displayed in a fourth area D4 on the display screen of the display apparatus D, which shows the progression status by displaying the words, numeric value, and graphic (progression bar). Furthermore, after the start of the liquid recovery operation, the state of the nozzle member 70 changes from a wet state to a dry state. Therefore, the displayed content in the third area D3 that indicates the state of the nozzle member is changed. As described above, the time from start to completion of the liquid recovery operation is relatively short. Therefore, display of a progression bar, etc., as shown in FIG. 13 may be omitted.

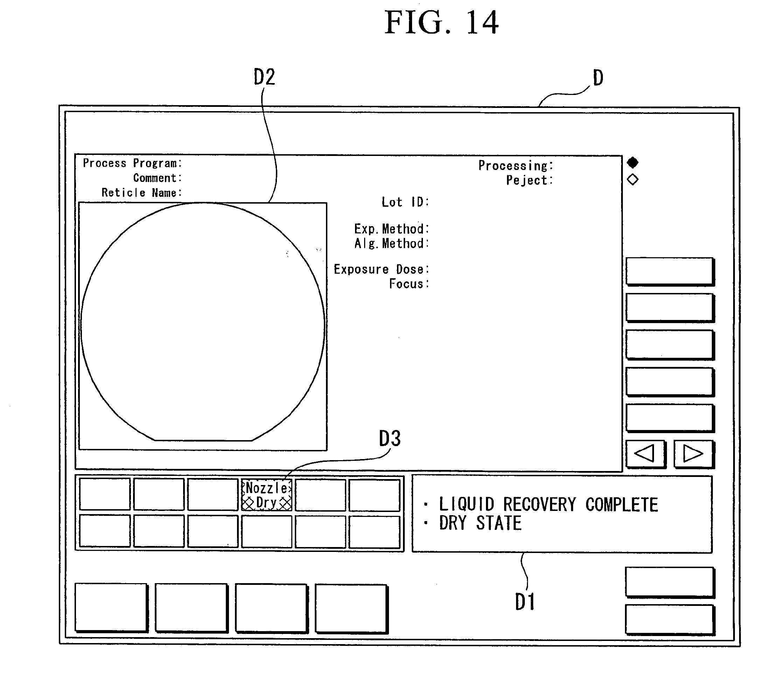

FIG. 14 shows an example of displayed content on the display apparatus D at the aforementioned step SA7, i.e., at the completion of the liquid recovery operation. As shown in FIG. 14, the first area D1 on the display screen of the display apparatus D indicates that the liquid recovery operation has completed by displaying the words "Liquid Recovery Complete". Furthermore, at the completion of the liquid recovery operation, the display apparatus D indicates that the optical path space K1 is in a state free from the liquid LQ (a dry state). In FIG 14, the first area D1 on the display screen of the display apparatus D indicates that the optical path space K1 is in a state free from the liquid LQ by displaying the words "Dry State".

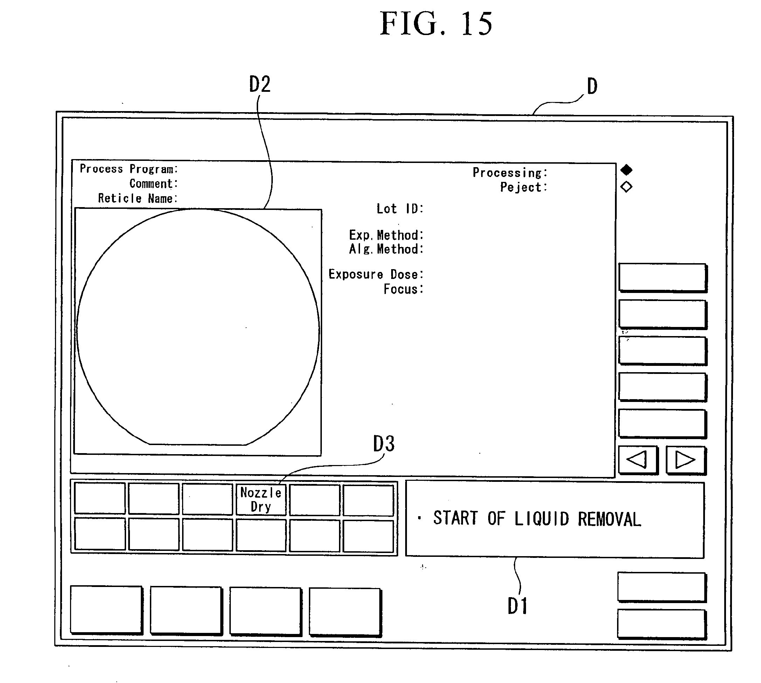

FIG 15 shows an example of displayed content on the display apparatus D at the aforementioned step SA8, i.e., at the start of the liquid removal operation. As shown in FIG 15, the first area D1 on the display screen of the display apparatus D indicates that the liquid removal operation has started by displaying the words "Start of Liquid Removal".

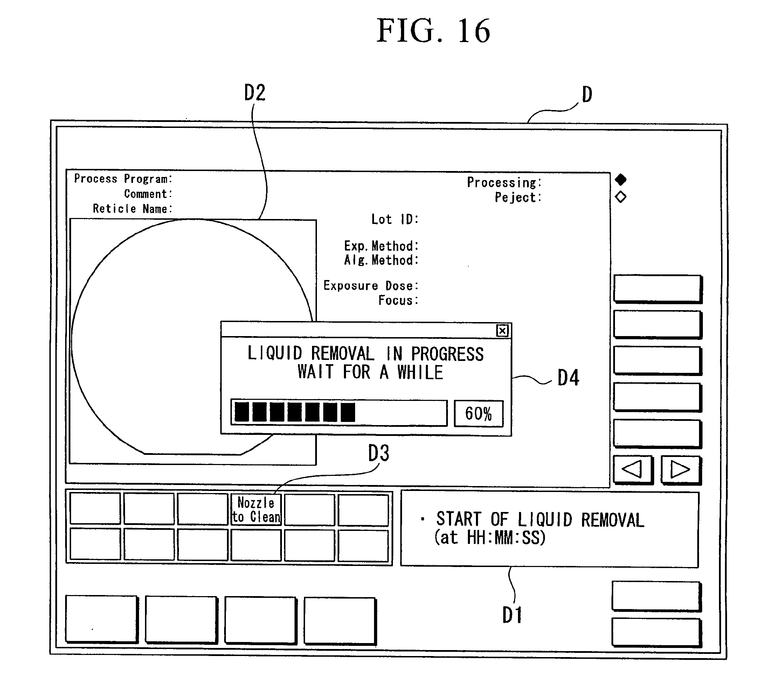

FIG. 16 shows an example of displayed content on the display apparatus D at the aforementioned step SA9, i.e., during the liquid removal operation. As shown in FIG. 16, the display screen of the display apparatus D indicates that, as a progression status of the liquid removal operation, the liquid removal operation is in progress. To indicate the progression status of the liquid removal operation, a window is displayed in the fourth area D4 on the display screen of the display apparatus D, which shows the progression status by displaying the words, numeric value, and graphic (progression bar). Furthermore, after the start of the liquid removal operation, the displayed content in the third area D3 is changed so as to indicate a state in which the nozzle member 70 is performing the liquid removal operation.

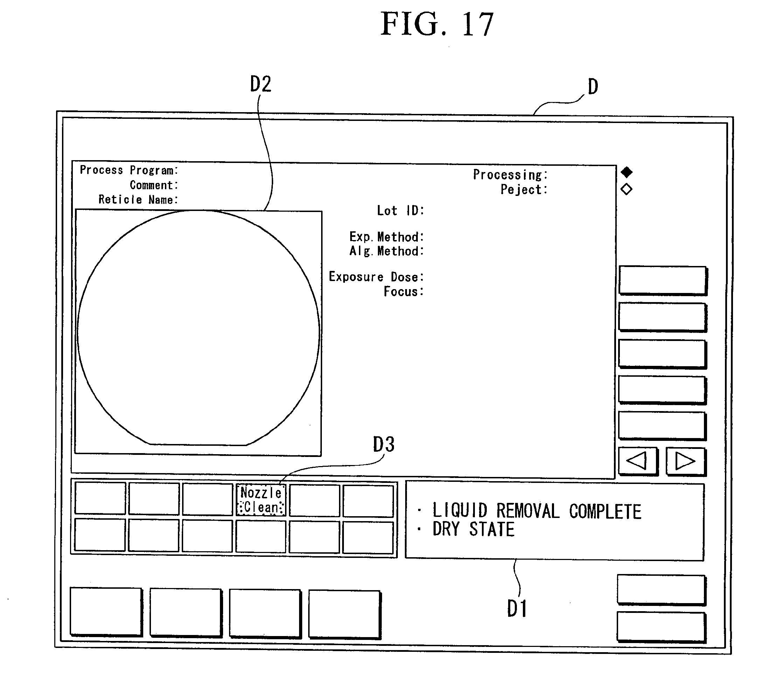

FIG 17 shows an example of displayed content on the display apparatus D at the aforementioned step SA10, i.e., at the completion of the liquid removal operation. As shown in FIG. 17, the first area D1 on the display screen of the display apparatus D indicates that the liquid removal operation has completed by displaying the words "Liquid Removal Complete". Furthermore, at the completion of the liquid removal operation, the display apparatus D indicates that the optical path space K1 is in a state free from the liquid LQ (a dry state) by displaying the words "Dry State". Moreover, the displayed content in the third area D3 is changed so as to indicate that the nozzle member 70 has completed the liquid removal operation.

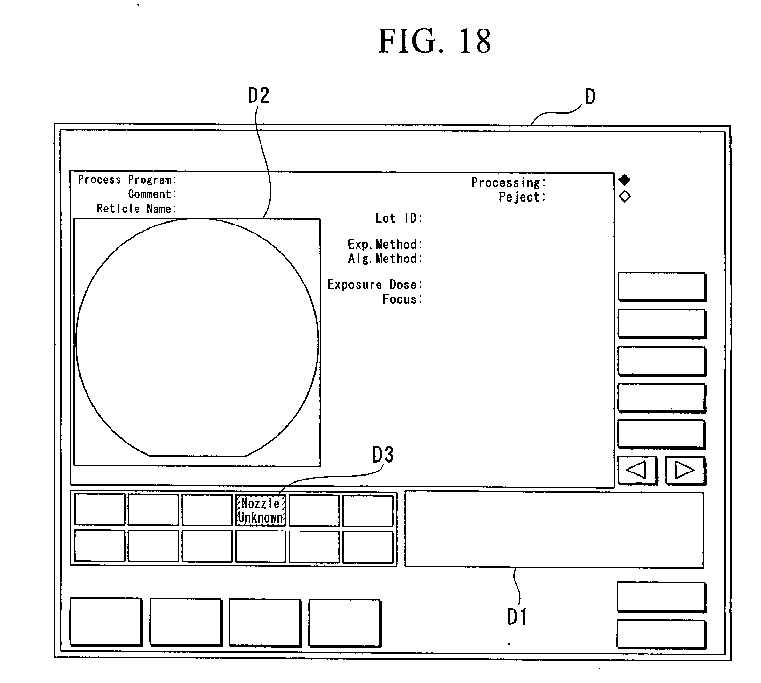

Furthermore, as shown in FIG. 18, the display apparatus D can indicate that an error or the like has occurred in the exposure apparatus EX. In an example shown in FIG 18, an example is shown when the presence or absence of the liquid LQ in the optical path space K1 is uncertain due to the occurrence of an error or the like.

As described above, with the display of the display apparatus D, the operator or others can know a progression status when filling the optical path space K1 of the exposure light EL with the liquid LQ and a progression status when removing the liquid LQ from the optical path space K1. Therefore, indeed leakage, scattering or the like of the liquid LQ occurs when the operator or others move the substrate P or substrate stage PST that faces the projection optical system PL out from directly under the projection optical system PL during the liquid filling operation, the liquid recovery operation, or the liquid removal operation, but the progression status of the liquid filling operation, the liquid recovery operation, or the liquid removal operation can be known from the display of the display apparatus D. Thus, the aforementioned leakage and scattering of the liquid LQ can be prevented. Therefore, changes, due to the leaked or scattered liquid LQ, in an environment in which the exposure apparatus EX is set, and the formation of rust on and the occurrence of failures or the like in each of the devices and members that constitute the exposure apparatus EX due to the leaked or scattered liquid LQ can be prevented. Thus, the substrate P can be exposed with good accuracy using the exposure apparatus EX.

In the aforementioned embodiment, the display apparatus D indicates both of a progression status when filling the optical path space K1 of the exposure light EL with the liquid LQ and a progression status when removing the liquid LQ from the optical path space K1. However the display apparatus D may be adapted to display only either one of the two.

In the aforementioned embodiment, it is configured such that the first to fourth sensors 31 to 34 are used to detect progression statuses of the liquid filling operation and the liquid recovery operation so as to perform a display on the display apparatus D based on the results. However, these sensors need not be provided. In this case, the time from the start of the liquid filling operation until when the optical path space K1 is filled with the liquid LQ may be acquired in advance, for example, by an experiment or a simulation so as to store the information on the acquired time. Then, based on the stored information, a progression status of the liquid filling operation may be known; the time until the completion of the liquid filling operation may be acquired; the progression status may be displayed on the display apparatus D; or it may be determined whether the liquid filling operation has completed or not. Similarly, as for the liquid recovery operation, the time until completion of the liquid recovery operation may be acquired; a progression status may be displayed on the display apparatus D; or completion of the liquid recovery operation may be determined, based on the stored information on the time.

Furthermore, in the aforementioned embodiment, the liquid removal operation is performed after completion of the liquid recovery operation. However, in the case where the remaining liquid LQ is small or the remainder of the liquid LQ is allowable, the liquid removal operation (steps SA8 to SA10) may be omitted.

Furthermore, the positional relationship between the substrate P and the liquid immersion region LR may be displayed by adding the liquid immersion region LR to the second area D2 on the display screen of the display apparatus D.

As described above, the liquid LQ in this embodiment is pure water. Pure water has advantages in that it can be easily obtained in large quantity at semiconductor manufacturing plants, etc. and in that it has no adverse effects on the photoresist on the substrate P or on the optical elements (lenses), etc. In addition, pure water has no adverse effects on the environment and contains very few impurities, so one can also expect an action whereby the surface of the substrate P and the surface of the optical element provided on the front end surface of the projection optical system PL are cleaned. In the case where pure water supplied from plants, etc. has a low degree of purity, the exposure apparatus may have an extra pure water production apparatus.

In addition, the index of refraction n of pure water (water) with respect to the exposure light EL with a wavelength of 193 nm is said to be nearly 1.44, so in the case where ArF excimer laser beam (193 nm wavelength) is used as the light source of the exposure light EL, it is possible to shorten the wavelength to 1/n, that is, approximately 134 nm on the substrate P, to obtain high resolution. Also, the depth of focus is expanded by approximately n times, that is approximately 1.44 times, compared with it being in air, so in the case where it would be permissible to ensure the same level of depth of focus as the case in which it is used in air, it is possible to further increase the numerical aperture of the projection optical system PL, and resolution improves on this point as well.

In this embodiment, an optical element LS 1 is attached to the front end of the projection optical system PL, and this lens can be used to adjust the optical characteristics, for example, the aberration (spherical aberration, coma aberration, etc.), of the projection optical system PL. Note that an optical plate used for the adjustment of the optical characteristics of the projection optical system PL may also be used as the optical element attached to the front end of the projection optical system PL. Or, it may also be a plane-parallel plate through which the exposure light EL is able to pass.

Furthermore, in the projection optical system of the above embodiment, the optical path space on the image plane side of the optical element at the front end is filled with a liquid, but a projection optical system, as disclosed in PCT International Publication No. WO 2004/019128, in which the optical path space on the mask side of the optical element at the front end is also filled with a liquid, may be adopted. In this case, it may be configured such that at least one of a progression status of the liquid filling operation and a progression status of the liquid recovery operation of the optical path space on the mask side is displayed on the display apparatus D.

Note that the liquid LQ of this embodiments is water, but it may be a liquid other than water. For example, if the light source of the exposure light EL is an F₂ laser, this F₂ laser beam will not pass through water, so the liquid 2 may be, for example, a fluorocarbon fluid such as a perfluoropolyether (PFPE) or a fluorocarbon oil that an F₂ laser is able to pass through. In this case, the part to be in contact with the liquid LQ is applied with lyophilic treatment by forming a thin film using a substance with a molecular structure that has a small polarity including fluorine. In addition, it is also possible to use, as the liquid LQ, liquids that have the transmittance with respect to the exposure light EL and whose refractive index are as high as possible and that are stable with respect to the photoresist coated on the projection optical system PL or the surface of the substrate P (for example, cedar oil). Also in this case, the surface treatment is performed in accordance with the polarity of the liquid LQ to be used.

It is to be noted that as for substrate P of each of the above-described embodiments, not only a semiconductor wafer for manufacturing a semiconductor device, but also a glass substrate for a display device, a ceramic wafer for a thin film magnetic head, or a master mask or reticle (synthetic quartz or silicon wafer), etc. can be used.

As for exposure apparatus EX, in addition to a scan type exposure apparatus (scanning stepper) in which while synchronously moving the mask M and the substrate P, the pattern of the mask M is scan-exposed, a step-and-repeat type projection exposure apparatus (stepper) in which the pattern of the mask M is exposed at one time in the condition that the mask M and the substrate P are stationary, and the substrate P is successively moved stepwise can be used.

Furthermore, the present invention can also be applied to a twin stage type exposure apparatus as disclosed for example in Japanese Unexamined Patent Application, First Publication No. H10-163099, Japanese Unexamined Patent Application, First Publication No. H10-214783, and Published Japanese Translation No. 2000-505958 of PCT International Application.

Furthermore, the present invention can also be applied to an exposure apparatus furnished with a substrate stage and a measurement stage as disclosed for example, in Japanese Unexamined Patent Application, First Publication No. H11-135400. In this case, at least either one of the above-described liquid filling operation and liquid recovery operation may be performed in the state with the projection optical system PL facing the measurement stage.

Furthermore, in the above embodiments, an exposure apparatus in which the liquid is locally filled in the space between the projection optical system PL and the substrate P is used. However, the present invention can be also applied to a liquid immersion exposure apparatus in which exposure is performed in a state with the whole surface of the target exposure substrate being immersed in a liquid, as disclosed for example in Japanese Unexamined Patent Application, First Publication No. H06-124873, Japanese Unexamined Patent Application, First Publication No. H10-303144, and U.S. Patent No. 5,825,043.

As for the types of exposure apparatuses EX, the present invention is not limited to exposure apparatuses for semiconductor element manufacture that expose a semiconductor element pattern onto a substrate P, but are also widely applicable to exposure apparatuses for the manufacture of liquid crystal display elements and for the manufacture of displays, and exposure apparatuses for the manufacture of thin film magnetic heads, image pickup devices (CCDs), and reticles or masks.

The exposure apparatus EX of this embodiment is manufactured by assembling various subsystems, including the respective constituent elements presented in the Scope of Patents Claims of the present application, so that the prescribed mechanical precision, electrical precision and optical precision can be maintained. To ensure these respective precisions, performed before and after this assembly are adjustments for achieving optical precision with respect to the various optical systems, adjustments for achieving mechanical precision with respect to the various mechanical systems, and adjustments for achieving electrical precision with respect to the various electrical systems. The process of assembly from the various subsystems to the exposure apparatus includes mechanical connections, electrical circuit wiring connections, air pressure circuit piping connections, etc. among the various subsystems. Obviously, before the process of assembly from these various subsystems to the exposure apparatus, there are the processes of individual assembly of the respective subsystems. When the process of assembly to the exposure apparatuses of the various subsystems has ended, overall assembly is performed, and the various precisions are ensured for the exposure apparatus as a whole. Note that it is preferable that the manufacture of the exposure apparatus be performed in a clean room in which the temperature, the degree of cleanliness, etc. are controlled.

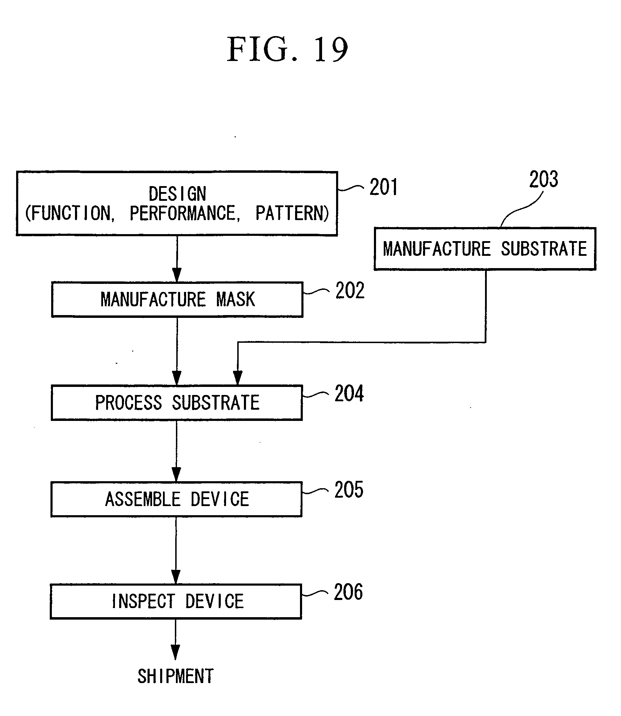

As shown in FIG. 19, microdevices such as semiconductor devices are manufactured by going through: a step 201 that performs micro device function and performance design, a step 202 that creates the mask (reticle) based on this design step, a step 203 that manufactures the substrate that is the device base material, a substrate processing step 204 that includes a process for exposing the pattern of the mask onto a substrate by means of the exposure apparatus EX of the aforementioned embodiments, a device assembly step (including a dicing process, a bonding process and a packaging process) 205, and an inspection step 206, and so on.

## Claims

1. An exposure apparatus that irradiates a substrate with exposure light via a liquid to expose the substrate, comprising
a display apparatus that indicates at least one of a status of filling of an optical path space of the exposure light with the liquid and a status of recovery of the liquid from the optical path space.

2. The exposure apparatus according to claim 1, wherein, when filling of the optical path space with the liquid is completed, the display apparatus indicates that the optical path space is in a state of being filled with a liquid.

3. The exposure apparatus according to claim 1 or 2, wherein, when recovery of the liquid from the optical path space is completed, the display apparatus indicates that the optical path space is in a state free from a liquid.

4. The exposure apparatus according to any one of claims 1 to 3, further comprising
a sensor that detects a size of a liquid immersion region consisting of the liquid at the optical path space, wherein
the display apparatus indicates at least one of the status of filling with the liquid and the status of recovery of the liquid based on a detection result from the sensor.

5. The exposure apparatus according to any one of claims 1 to 4, wherein
the display apparatus indicates a status of removal of the liquid remaining on the substrate, after completion of recovery of the liquid from the optical path space.

6. The exposure apparatus according to any one of claims 1 to 5, further comprising
a projection optical system from which the exposure light exits, wherein
the optical path space comprises a space between an object and the projection optical system, the object facing the projection optical system.

7. The exposure apparatus according to claim 6, wherein the display apparatus indicates whether or not the space between the projection optical system and the object is filled with a liquid.

8. The exposure apparatus according to claim 7, wherein the display apparatus also indicates that the determination whether or not the space between the projection optical system and the object is filled with a liquid cannot be made.

9. A device manufacturing method using the exposure apparatus according to any one of claims 1 to 8.
